# EUROPEAN PATENT APPLICATION

(11) **EP 2 042 926 A2**
(43) Date of publication of application: **01.04.2009**
(21) Application number: 08016858.6
(22) Date of filing: 25.09.2008
(51) Int. Cl.: G03F 7/09, G03F 7/16

(54) **Method for manufacturing original plate of planographic printing plate and original plate of planographic printing plate**

(30) Priority: 28.09.2007 JP 2007256691
(71) Applicant: Fujifilm Corporation, Tokyo 106-8620 (JP)
(72) Inventor: Hayashi, Kenji, Haibara-gun Shizuoka (JP)
(74) Representative: HOFFMANN EITLE

(57) **Abstract**

An aspect of the present invention provides a method for manufacturing an original plate (14A) of a planographic printing plate, characterized by comprising: a process of forming a photosensitive layer on a substrate (14); a process of coating an overcoat layer over the photosensitive layer; a first drying process of supplying hot air toward the overcoat layer; and a second drying process of supplying hot air and superheated vapor (S) toward the overcoat layer after the first drying process, wherein the original plate (14A) of a planographic printing plate is photopolymerizable.

## Description

### BACKGROUND OF THE INVENTION

### 1. Field of the Invention

The present invention relates to a method for manufacturing an original plate of a planographic printing plate and to an original plate of a planographic printing plate. Particularly, the present invention relates to a method for manufacturing an original plate of a planographic printing plate which has an overcoat layer on a photopolymerized layer (photosensitive layer) and an original plate of a planographic printing plate manufactured by the method.

### 2. Related Art

In a production of a photopolymerizable planographic printing plate having an overcoat layer which contains a water-soluble polymer as its main component including hydrogen bonding group, enhancing sensitivity is an important factor, and a lot of photosensitive systems taking advantage of a radical polymerization profitable for enhancing sensitivity are investigated and developed. However, because the radical polymerization system is vulnerable to receive an inhibition of polymerization by oxygen, ideas of raising a polymerization efficiency are tried by providing, for example, an overcoat layer superior in an oxygen blocking property containing a polyvinyl alcohol (PVA) as its main component on the photopolymerization layer. When the oxygen permeation rate of the overcoat layer is too large, a large amount of oxygen will be supplied into the photosensitive layer, and the sensitivity of the prepared photopolymerizable presensitized printing plate will decrease. On the contrary, when the oxygen permeation rate is too small, the amount of oxygen supplied into the photosensitive layer will decrease and the sensitivity will rise remarkably, resultantly promoting the polymerization reaction by heating or pressing and it is unfavorable because a remaining membrane, a residual color, an underdevelopment or the like will occur. Accordingly, it is required for the overcoat layer to have an appropriate oxygen permeability.

Because the oxygen permeability of the overcoat layer is largely infected with the moisture content of the overcoat layer, the amount of oxygen in the overcoat layer was conventionally controlled by adjusting the moisture content of the overcoat layer within a predetermined range by passing the substrate through a humidifying zone with both a predetermined constant temperature and a constant humidity after applying the overcoat layer over the photopolymerization layer (see Japanese Patent Application Laid-Open No. 2005-107388).

Further, it is proposed to spread the tolerant range of the temperature and the humidity in a humidifying zone by arranging the crystallinity of the overcoat layer from 0.2 to 0.5 (see Japanese Patent Application Laid-Open No. 2005-326493). Furthermore, in order for highly precisely adjusting the moisture content of the overcoat layer, a device for adjusting the water content of the coated membrane with a detecting means of the moisture content in the humidifying zone is proposed (see Japanese Patent Application Laid-Open No. 2003-228176).

Moreover, it is proposed in the field of printing to adjust the moisture content of a printed sheet by heating and drying in accordance with blowing superheated vapor onto a printing ink (see Japanese Patent Application Laid-Open No. 2002-19310).

However, in the production of the presensitized printing plate described in the former three patent documents, the amount of the water content supplied into the overcoat layer is determined by the conditions of the temperature, the humidity and the detention time in the humidifying zone because the water content in the overcoat layer is adjusted by passing a continuous web support, over which the overcoat layer is applied, through the humidifying zone while continuously conveying the support. Accordingly, in the case where a conveying velocity of the support is increased with a purpose of improving the productivity, an enhancement of a humidifying capacity such as prolonging the passage length of the humidifying zone or the like is necessary. However, when there is not any enlargement space for the humidifying zone, the enhancement cannot be easily realized.

Regarding with Japanese Patent Application Laid-Open No. 2002-19310, it relates to drying of printing ink in the field of printing, and only drying with the superheated vapor is carried out after printing without any relation with the production of the presensitized printing plate.

### SUMMARY OF THE INVENTION

In view of such circumstances, the object of the present invention is to provide a method for manufacturing an original plate of a planographic printing plate and to provide an original plate of a planographic printing plate, both of which enable to improve the productivity and also contribute to cost saving and space saving without needing to prolong the length of the passage of the humidifying zone.

To achieve the above object, the present invention provides a method for manufacturing an original plate of a planographic printing plate, characterized by comprising: a process of forming a photosensitive layer on a substrate, a process of applying an overcoat layer over the photosensitive layer, the first drying process of supplying hot air toward the overcoat layer, and the second drying process of supplying hot air and superheated vapor toward the overcoat layer after the first drying process, wherein the original printing plate of a planographic printing plate is photopolymerizable.

In the conventional drying of the overcoat layer, there was a defect that an inferior quality occurs caused by a change of the state of the overcoat layer depending on the situation of being heated and containing moisture.

For example, in a case where the water component among the overcoat layer is dried in accordance with a conventional drying method (using heated air at the temperature not less than 60 °C and with a dew-point of 5 to 20 °C) in drying the overcoat layer containing polyvinyl alcohol as its main component, there was a defect that the membrane temperature of the overcoat layer cannot be raised only up to 40-60 °C when the water component in the membrane is tried to be controlled to a required amount (when drying the water component is discontinued on a halfway) in the situation because the drying of constant rate drying period is carried out when the temperature of the membrane surface is at about an wet-bulb temperature (40 to 60 °C) in its evaporation time. Further, because variations both in a remaining water component among the membrane and in a heating amount inside the membrane tend to occur, there was a shortcoming that a desired molecular situation and water containing situation cannot be form in the overcoat layer. Therefore, the desired molecular situation and water containing situation are formed by heating the overcoat layer up to a temperature of around 100 °C, together with decreasing the moisture content of the entire membrane down to around 0 %, and after reducing the variation of the moisture content, thereby obtaining the required moisture content by adding the water component again under the condition of constant temperature and constant humidity.

In the present invention, removing, at first, the water component in the membrane within ± 10% of the critical moisture content of the overcoat layer by means of the first drying process, and after the first drying process, the water component in a superheated condition will be allowed to permeate into the membrane using the superheated vapor by means of the second drying process supplying hot air and the superheated vapor into the overcoat layer. In this occasion, because the membrane can be heated using the superheated vapor at the temperature of around 100 °C being the boiling point of water, it is possible to form the desired molecular situation of the overcoat layer and to adjust the water component among the membrane uniformly and rapidly.

In the method for manufacturing an original plate of a planographic printing plate of the present invention, because the overcoat layer is dried while supplying hot air and the superheated vapor, the overcoat layer immediately after the second drying process is not in the state of absolute dry condition but holding the constant and necessary moisture content. After drying, the web can be wound up either while maintaining the above state in the humidifying process under the condition of constant temperature and constant humidity or still after controlling the amount of the water component more highly precisely in the humidifying process. Because the drying is carried out in an elevated temperature, in the case where it becomes necessary to prevent the overcoated membrane from transferring onto pass rollers and to suppress the change with the lapse of time after winding up, it may be appropriate to adjust the moisture content in the humidifying process under the condition of constant temperature and constant humidity.

From the above described reasons, the drying time and the humidifying time are shortened as compared with the conventional technique, and it becomes possible to improve the productivity without needing to prolong the length of the passage of the humidifying zone and accordingly, cost saving and space saving also become possible.

Additionally, the term "superheated vapor" here may mean a superheated steam, and may be prepared by mixing the superheated steam and other gases.

In the method for manufacturing the original plate of the planographic printing plate of the present invention, it is preferable that the overcoat layer contains a water-soluble polymer. When the overcoat layer is the water-soluble polymer, drying it while feeding hot air and the superheated vapor enables the overcoat layer immediately after the second drying process to have constant moisture content. When the overcoat layer contains the water-soluble polymer, the overcoat layer is dried fundamentally by evaporating water in the drying process. In the second drying process, over drying is prevented by supplementing water into the overcoat layer while evaporating water and spraying superheated vapor onto the overcoat layer.

In the method for manufacturing an original plate of a planographic printing plate of the present invention, it is preferable that the water-soluble polymer is the water-soluble polymer whose main component is polyvinyl alcohol. The reason of the above description is that the water-soluble polymer whose main component is polyvinyl alcohol is suited as an overcoat layer for an original plate of a planographic printing plate.

In the method for manufacturing an original plate of a planographic printing plate of the present invention, it is preferable that the second drying process starts when the moisture content of the overcoat layer is within ± 10 % of its critical moisture content. The aspect of the present invention is characterized in that the second drying process is advanced particularly at a point where the drying shifts from constant-rate drying period into reducing rate drying period, in other words, adjacent to where the moisture content of the overcoat layer corresponds to a critical moisture content or afterwards. Advancing the second drying process at a point adjacent to where the moisture content of the overcoat layer corresponds to a critical moisture content or afterwards enables to prevent the overcoat layer from being dried up to absolute dry condition.

In the method for manufacturing an original plate of a planographic printing plate of the present invention, it is preferable that supplying time of the superheated vapor is not less than 0.5 second but not more than 15 seconds. When the supplying time is shorter than 0.5 second, heating of the overcoat layer by the superheated vapor is not sufficient, and the desired molecular state cannot be obtained. Also, variations of the water component in the membrane are so tremendous that the amount of the water component in the membrane should be adjusted highly precisely, humidifying time becomes long. Further, feeding the superheated vapor for longer than 15 seconds will raise the moisture content of the overcoat layer thereby causing the need of drying again.

In the method for manufacturing an original plate of a planographic printing plate of the present invention, it is preferable that supplying amount of the superheated vapor is not less than 50 g/m³ but not more than 500 g/m³, and more preferably not less than 100 g/m³ but not more than 400 g/m³. The supplying amount of the superheated vapor within the above range will produce the effect of excluding a danger of dew generation and of feeding the superheated vapor into the overcoat layer effectively.

In the method for manufacturing an original plate of a planographic printing plate of the present invention, it is preferable that temperature of the superheated vapor is within ± 20 °C and preferably within ± 5 °C of temperature of the hot air. The temperature of the superheated vapor within the above range will produce the effect of stabilizing the state of the superheated vapor without generating water drops.

In the method for manufacturing an original plate of a planographic printing plate of the present invention, it is preferable that the method further comprises a process of cooling down the substrate over which the photosensitive layer and the overcoat layer are formed and a process of adjusting the moisture content of the overcoat layer after the process for cooling down the substrate.

The humidifying process in a constant temperature and constant humidity condition after drying process is executed at the temperature near an ordinary temperature as compared with the drying process in order to prevent a variation of the moisture content after winding up the substrate. While preventing the overcoat membrane from transferring onto pass rollers, for the purpose of adjusting the water component in a short time, the humidifying process will be executed in the form of adding water component in proportion to time ordinarily under conditions of at the temperature of 25 °C, the humidity of 55 % HR (relative humidity), etc. By executing the above technique, the desired molecular state is held and the overcoat layer containing a necessary amount of the water component is formed.

In the method for manufacturing an original plate of a planographic printing plate of the present invention, it is preferable that the process of cooling down the substrate is controlled by dew-point of not more than 18 °C, and wherein the temperature of the substrate is controlled within a range of 25 °C to 40 °C by a wind with the temperature of 20 ± 5 °C. That is for the purpose of preventing dew generation on the overcoat layer during the cooling process.

An original plate of a planographic printing plate according to the present invention is characterized in that the original plate is manufactured by the above-described manufacturing method. By manufacturing an original plate of a planographic printing plate having the overcoat layer in accordance with the above method, a temperature elevation in the photosensitive layer is suppressed and a fear such as a progress of a reaction by heating or the like will be excluded. Also, because the drying is executed with uniform condition in a widthwise direction of the original plate of the planographic printing plate, a widthwise distribution of its characteristics will be excluded.

According to the method for manufacturing an original plate of a planographic printing plate of the present invention, the productivity can be improved by adding the drying process which supplies the superheated vapor. Further, because it is not necessary to prolong the length of the passage of the humidifying zone, the present invention contributes to cost saving and space saving.

### BRIEF DESCRIPTION OF THE DRAWINGS

Fig. 1 is an explanatory drawing for illustrating a production line of an original plate of a planographic printing plate in the present embodiment;
Fig. 2 is an explanatory drawing for illustrating a drying apparatus in the present embodiment; and
Fig. 3 is a graph showing a relation between water contents of the overcoat layer and the lapse of time.

### PREFERRED EMBODIMENT TO CARRY OUT THE INVENTION

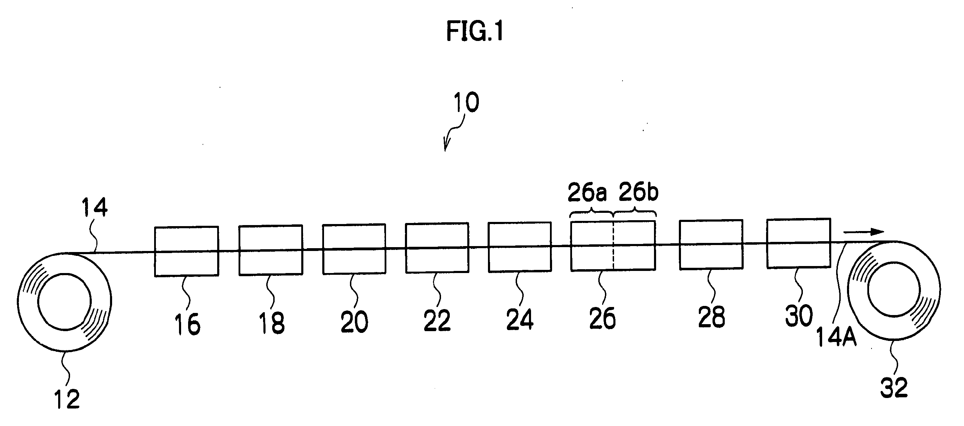

Preferred embodiments of the method for manufacturing an original plate of a planographic printing plate according to the present invention will now be described in detail with reference to the accompanying drawings. Fig. 1 illustrates an embodiment of a production line 10 of the original plate of the planographic printing plate in the present invention and the following will describe the production line 10.

As shown in Fig. 1, a long continuous support 14 wound into a roll-shape is set in an unwinder 12. Onto the support 14 continually sent out from the unwinder 12, a surface treatment is proceeded in a surface treatment section 16.

A dimensionally stable aluminum or its alloy (an alloy with, for example, silicon, copper, manganese, magnesium, chromium, zinc, lead, bismuth, and nickel) is employable as the support 14 in the present invention. Usually, conventionally well known raw materials described in the fourth edition of Aluminum Handbook (1990, published by Light Metal Association), for example, JIS A1050 material, JIS A1100 material, JIS A3103 material, JIS A3004 material, JIS A3005 material or alloys prepared by adding not less than 0.1 % by weight of magnesium into them for the purposes of increasing their tensile strengths are employed.

When the support 14 is an aluminum plate, it is an ordinary case that its surface is subjected to various treatments depending on the purposes in the surface treatment section 16. As the general treatment method, the surface of aluminum is cleaned by firstly subjecting to defatting treatment or to electrolytic polishing treatment and desmutting treatment onto the aluminum plate. Subsequently, fine irregularities is added onto the surface of the aluminum plate by subjecting it to a mechanical roughening treatment or / and an electrochemical roughening treatment. Additionally, there is a case where a chemical etching treatment or a desmutting treatment is further added at this time. Further subsequently, an anodic oxidation is executed in order to elevate an abrasion resistance onto the surface of the aluminum plate and then, a hydrophilizing treatment or / and sealing of the anodic oxide will be proceeded onto the surface of aluminum as occasion demands.

It is preferable that wiping out of the liquid by nip rollers and water washing by spraying or the like are carried out in order not to bring the treatment liquid of its pretreatment into the next treatment between respective treatments. Additionally, an overflowed waste liquid of the electrolytic solution after the usage for the electrochemical roughening treatment can be employed as the desmutt treatment liquid. In this case, the water washing treatment after the desmutting treatment may be abbreviated. In the defatting and electrolytic polishing treatment, rolling oil, natural oxidation membrane, stains and the like on the aluminum plate are removed.

For the purpose of making the electrochemical roughening uniform, an electrolytic polishing treatment of the aluminum plate among an acidic aqueous solution or a chemical etching treatment of the aluminum plate among an acidic or alkaline aqueous solution is proceeded. It is preferable that a dissolving amount of the aluminum plate by the treatment is dissolving 1 to 30 g/m², and further preferably dissolving 1.5 to 20 g/m².

In the case where a chemical etching is executed using a basic aqueous solution in the desmutting treatment, the treatment is proceeded employing a phosphoric acid, a nitric acid, a sulfuric acid, a chromic acid or a mixed acid containing 2 or more of those acids because a smut generates, in general, on the surface of aluminum.

Subsequently, in a backcoat layer coating and drying section 18, a covering layer (backcoat layer) containing an organic polymer chemical compound for preventing an attachment of scratch when the substrates are stacked will be applied onto the back surface of the support 14 as occasion demands. As a main component of the backcoat layer, at least one kind of resin selected from a group including a saturated copolyester resin, phenoxy resin, polyvinylacetal resin and vinylidene chloride copolymerization resin each having a glass transition point of not less than 20 °C is used.

Then, in an undercoat coating and drying section 20, an undercoat layer is formed by applying an undercoat coating solution over the surface of the support 14 as occasion demands, followed by drying. Regarding with coating manners and conditions in the undercoat coating and drying section 20, most of manners and conditions for applying photosensitive composition layer which will be described later can be utilized.

Subsequently, in a photosensitive layer coating and drying section 22, a photosensitive layer is formed by applying and drying a coating material of photopolymerization type photosensitive composition over the undercoat layer.

As a solvent for dissolving photopolymerization type photosensitive composition, the organic solvent such as described in Japanese Patent Application Laid-Open No. 62-251739, Japanese Patent Application Laid-Open No. 6-242597 or the like is employed. The photopolymerization type photosensitive composition is dissolved and dispersed with solid content concentration of 2 to 50 % by weight and applied and dried over the support 14. Although a coating amount of the photopolymerization type photosensitive composition layer (photosensitive layer) applied over the support 14 is different depending on its usage, it is preferable, in general, to be 0.3 to 4.0 g/m² as its weight after drying. Accompanying with the decrease of the coating amount, light exposure for taking a pictorial image may be allowable to be small; however, membrane strength will degrade. Accompanying with the increase of the coating amount, the light exposure becomes necessary to be large, however, the photosensitive membrane will become strong and, for example, in the usage as a lithographic printing plate, the printing plate capable of expecting a large number of sheets to be printed (high printing durability) can be obtained. Into the photosensitive composition, a surface active agent, particularly preferably a fluorine-based surface active agent may be added to improve the quality of the coated surface.

The photopolymerization type photosensitive composition for composing the photosensitive layer used for the present invention contains additively polymerizable ethyleny unsaturated compound, light initiator, and polymer binders as its essential composition, and it is possible to use various kinds of chemical agent such as a colorant, a plasticizer, a thermal polymerization inhibitor and so on together, as occasion demands. The ethyleny unsaturated compound corresponds to such a compound having an ethyleny unsaturated bond which polymerizes by addition, crosskinks and hardens by an operation of a photoinitiator when the photopolymerization type photosensitive composition receives radiation of active beam.

In a backcoat layer coating and drying section 18, in an undercoat coating and drying section 20 and in a photosensitive layer coating and drying section 22, a method such as employing a coating rod, employing an extrusion type coating machine or employing a slide bead coating machine is usable as methods for applying the backcoat layer, the undercoat layer and the photosensitive layer.

In the backcoat layer coating and drying section 18, in the undercoat coating and drying section 20 and in the photosensitive layer coating and drying section 22, a method such as a drying method deploying pass rollers in a drying apparatus, drying while conveying a support by making it wrapping the rollers, by blowing a hot air; a method for drying while rising up the support to surface by feeding air through nozzles from top and bottom surfaces of the support; a method for drying with an irradiated heat from the hot plate disposed above and below of a web support, or a drying method introducing heat mediums into insides of rollers, heating the mediums and drying with heat conduction by contact between the rollers and the support; is usable as methods for drying the backcoat layer, the undercoat layer and the photosensitive layer.

In any of those method, the control of heating is carried out, for the purpose of uniformly drying the web made by applying the coating composition over the support, by appropriately changing the flow rate, the temperature and flowing manner of the hot air or the heat mediums depending on the kinds of support and coating composition, coating amount, kinds of the solvent, travelling speed and so on. Further, two or more kinds of the drying methods may be used in combination.

Subsequently, in an overcoat layer coating section 24, an overcoat layer (PVA (polyvinyl alcohol) coated membrane) having a water-soluble polymer containing hydrogen bonding group, for example, PVA as the main component is formed. With regard to the coating method, the same methods as for forming the backcoat layer, the undercoat layer and the photosensitive layer may be employed.

Examples of the water-soluble polymer having hydrogen bonding group contained in the overcoat layer include polyvinyl alcohol, its partial ester, ether and acetal, and copolymers containing unsubstituted vinyl alcohol unit in a substantial amount for possessing sufficient water solubility to them. Regarding with the polyvinyl alcohol, those hydrolyzed from 71 to 100 %, and with polymerization degree within the range of 300 to 2400 are exemplified. Specific examples include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-220, PVA-224, PVA-217EE, PVA-217E, PVA-220E, PVA-224E, PVA-405, PVA-420, PVA-613, L-8, and so on all available from KURARAY CO., LTD. Examples of the copolymer include polyvinylacetatechloroacetate or propionate, polyvinylformal and polyvinylacetal and those copolymer each hydrolyzed from 88 to 100 % respectively. Other useful examples of the polymer include polyvinylpyrrolidone, gelatin and gum Arabic, each of which may be used singly or in combination respectively. These water-soluble polymers are contained at the ratio of 30 to 99 %, preferably of 50 to 99 % with respect to the entire solid contents of the overcoat layer. There will be a case wherein the overcoat layer is applied to form a plurality of layer as occasion demands.

Further, an inorganic layer shaped compound may be contained in the overcoat layer. The inorganic layer shaped compounds are particles having thin plate-shaped configuration, and examples include mica group such as natural mica, synthetic mica and the like represented by the general formula **A**(**B**,**C**)₂-5**D**₄O₁₀ (OH, F, O)₂ [wherein **A** represents any one of K, Na and Ca; **B** and **C** each represents any one of Fe (II), Fe (III), Mn, Al, Mg, and V; and **D** represents Si or Al], and talc, tainiolite, montmorillonite, saponite, hectolite, zirconium phosphate and so on represented by the general formula: 3MgO-4SiO-H₂O.

The thin plate-shaped particles disperse into a binder in an overlapping manner each other, and a thin layer containing an inorganic compound is formed in the binder having the above PVA as the main component, thereby improving waterproofness, oxygen blocking property and membrane strength all the more.

Among the mica group, examples of the natural mica include white mica, soda mica, gold mica, black mica and scale mica. Further, examples of the synthetic mica include non-swelling property micas such fluorine gold mica KMg₃(AlSi₃O₁₀)F₂, potassium 4 silicon mica KMg_{2.5}(Si₄O₁₀)F₂ or so; swelling property mica such as Na tetrasililic mica NaMg_{2.5}(Si₄O₁₀)F₂, Na or Li tainiolite (Na, Li)Mg₂Li(Si₄O₁₀)F₂, montmorillonite series Na or Li hectolite (Na, Li)_{1/8}Mg_{2/5}Li_{1/8}(Si₄O₁₀)F₂ or so. Furthermore, a synthetic smectite is also useful.

The addition amount of the mica compound in the case where it is added into the overcoat layer is preferably from 1.0 to 30 % by mass with respect to the total solid contents in the overcoat layer, and more preferably within the range 2.0 to 20 % by mass.

Also, fine particles of organic resin may be contained in the overcoat layer. It is preferable that they have high affinity with a binder (for example, polyvinyl alcohol) of the overcoat layer and they are kneaded into the overcoat layer favorably, and that they do not separate from the surface of the overcoat layer.

Examples of the fine particles of organic resin with the above described property include poly(meth)acrylates, polystyrene and its derivative, polyolefins such as polyamides, polyimides, low density polyethylene, high density polyethylene, polypropylene or so and copolymer of those and poval; synthetic resin particles such as polyurethane, polyurea, polyesters or so; and natural polymer particles such as chitin, chitosan, cellulose, crosslink starch, crosslink cellulose or so. Among those, synthetic resin particles are advantageous in easiness of grain size control, easiness for controlling desired surface characteristics by surface modification.

It is preferable for the fine particles of organic resin that they contain silica component, and above all, it is particularly preferable that they are silica clad fine particles covered partially with a silica layer over the surface of the fine particles of organic resin. The existence of silica at least partially on the surface of the fine particles of organic resin achieves improvement in the affinity between the fine particles of organic resin and the binder (polyvinyl alcohol), resultantly suppressing their separation from the overcoat layer even when they receive an external stress against the overcoat layer. Accordingly, it is possible to maintain superior scratch resistance and superior adhesion resistance.

The addition amount of the fine particles of organic resin (fine particles covered by silica) when they are contained into the overcoat layer may be from 5 to 1000 mg/m².

Next, regarding with the support 14 on which the overcoat layer was applied, the overcoat layer is dried in the overcoat layer drying section 26. In the present invention, the overcoat layer drying section 26 includes at least the first drying section 26a and the second drying section 26b. In the first drying section 26a being the preceding half part of the overcoat layer drying section 26, the over coat layer is dried by hot air. The drying will be executed until the moisture content of the overcoat layer shifts from constant rate drying period to reducing rate drying period, in other words, until the moisture content of the overcoat layer becomes nearly the critical moisture content, that is, critical moisture content ± 10 %. Because the drying rate depends on diffusion at the surface of the layer in the early phase of the drying (constant rate drying period), the drying rate is faster when the drying air has low humidity, that is, when the superheated vapor is not fed, and as a result, an efficient drying can be expected.

In the second drying section 26b being latter half part of the overcoat layer drying section 26, the over coat layer will be dried using hot air and superheated vapor. In accordance with drying by feeding superheated vapor in the second drying section 26b, drying by heating is proceeded while preventing over drying that would loose even the necessary amount of water component, that is, preventing an absolute dry state of the over coat layer. The moisture content at the drying termination timing in the overcoat layer drying section 26 is controlled within the range of 2 to 8 % by weight.

Conventionally, when the drying of the overcoat layer is not enough, there was a fear that the overcoat layer sticks to nip rollers or the like. Sticking of the overcoat layer causes quality defectiveness of the original plate of the planographic printing plate and troubles and so on in a manufacturing apparatus. Further, when the heating of the overcoat layer is not enough, the desired molecular state cannot be achieved and quality defectiveness occurred. Accordingly in conventional drying process, taking variation in drying of the overcoat layer into consideration, over heating was executed until the overcoat layer becomes absolute dry condition. In other words, the adjustment of moisture content was not controlled in the drying process.

In the present invention, in accordance with drying by supplying superheated vapor in the second drying section 26b, it becomes possible to dry while controlling enough heating and moisture content within a target moisture content range of 2 to 8 %.

After drying the over coat layer in the overcoat layer drying section 26, the support 14 will be forcibly cooled by means of a cooling furnace down to the predetermined temperature in a cooling section 28. The cooling furnace is controlled to a dew-point of not higher than 18 °C and to a chilling air with a temperature of about 20 °C. Those conditions are settled to prevent growing dews on the surface membrane of the overcoat layer.

Subsequently, the moisture content of the support 14 cooled in the cooling section 28 will be adjusted in a humidifying section 30 to maintain the moisture content within a target range of 2 to 8 % by weight. The control of the moisture content in the overcoat layer is carried out by controlling the temperature and the humidity and detention time in the humidifying section 30. Conventionally, because the overcoat layer was dried until reaching absolute dry condition (for example, moisture content of 0 to 0.5 % by weight) in the drying section, comparably longer humidifying time was necessary to control the moisture content of the overcoat layer within the target range of 2 to 8 % by weight. In the present invention, because the drying is executed while adding superheated vapor in the second drying section 26b, it is possible to control the moisture content of the overcoat layer within the target range of 2 to 8 % by weight at the timing of terminating the drying. As a result, it is suitable to maintain the moisture content just as it is until winding up the substrate, and it is not necessary to control the detention time under the condition of constant temperature and constant humidity. Accordingly, it becomes possible to control the moisture content of the overcoat layer within the target moisture content range in a shorter time than the prior art. Therefore, the present invention can improve the productivity, and it contributes to cost saving and space saving because it is not necessary to increase the passage length of the drying zone and the humidifying zone.

The original plate of the planographic printing plate 14A sent forth from the humidifying section 30 will be once wound up into a roll shape by means of a rewinder 32. Afterwards, the original plate of the planographic printing plate 14A wound up into the roll shape will be sent to a sheet finishing section (not shown). In the sheet finishing section, after adhering a protection sheet (inserting paper) on to the overcoat layer, the original plate will be slit and cut into seat-shaped product size by means of a slitter and a cutter. In this case, an apparatus (not shown) for adjusting moisture content of the inserting paper into 2 to 10 % by weight, preferably into 4 to 6.5 % by weight and being capable of adjusting the temperature and humidity is deployed. This makes the photopolymerizable planographic printing plate to be adhered with the inserting paper for the purpose of preventing the moisture content of the overcoat layer from changing.

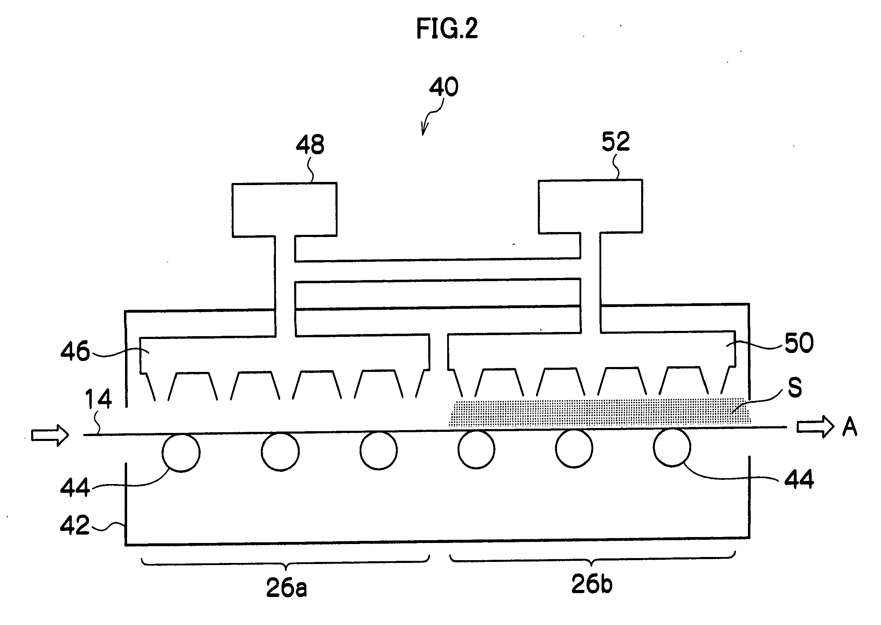

Fig. 2 shows an explanatory drawing for illustrating one example of constitution of the drying apparatus 40 applied for the present invention. As shown in Fig. 2, the drying apparatus 40 has a drying box 42 formed along with the conveyance direction of the support 14, and slit-shaped openings are formed at both ends of the drying box through which the support 14 advances in and out. At the inside of the drying box 42, a plurality of pass roller 44's is disposed for conveying the support 14.

The drying box 42 is constituted by the first drying section 26a that blows hot air onto the support 14 to dry it, and the second drying section 26b that blows hot air including superheated vapor onto the support 14 to dry it. Additionally in Fig. 2, an arrow A represents the conveyance direction of the support 14.

In the first drying section 26a, a plurality of nozzles 46 for blowing hot air onto the support 14 are disposed on the upper wall of the drying box 42. The nozzles 46 are connected to a hot air generator 48 via piping. This enables to blow hot air onto the support 14 for drying in the first drying section 26a.

In the second drying section 26b, a plurality of nozzles 50 for blowing hot air and superheated vapor onto the support 14 are disposed on the upper wall of the drying box 42. The nozzles 50 are connected to a hot air generator 48 and to a superheated vapor generator 52 via piping. This enables to blow hot air and superheated vapor S onto the support 14 for drying in the second drying section 26b. Additionally, regarding with the number of nozzle 46's and nozzle 50's, and the place for disposing them, they are not limited to the embodiment of Fig. 2. Further, in the embodiment of the drying apparatus 40, the nozzles 46 and nozzles 50 are connected to the same hot air generator 48, and the same hot air is fed into the first drying section 26a and the second drying section 26b. Different hot air generators may be provided for the first drying section 26a and for the second drying section 26b. Providing different hot air generators enables to differentiate drying conditions (for example, temperature and air rate of hot air) for the first drying section 26a and for the second drying section 26b.

In the drying section, the superheated vapor is blown from the nozzles 50 onto the overcoat layer for the time within the range of from 0.5 seconds to 15 seconds. When the feeding time is shorter than 0.5 seconds, both a shortage of heating and a variation of the moisture content in the overcoat layer increase and in this sense, it is preferable that the feeding time is not shorter than 0.5 seconds. Further, when the feeding time is longer than 15 seconds, the moisture content in the overcoat layer will elevate and a need for drying again will occur.

The superheated vapor is blown from nozzles 50 onto the overcoat layer with the feeding amount within the range of not less than 50 g/m³ but not more than 500 g/m³, and preferably not less than 100 g/m³ but not more than 400 g/m³.

Further, the temperature of the superheated vapor is controlled within ± 20 °C, preferably ± 5 °C with respect to the temperature of hot air. The temperature of the hot air is controlled within the range of 80 to 250 °C, preferably 100 to 200°C.

Referring to Fig. 2, the first drying section 26a and the second drying section 26b are deployed among the drying box 42. As another embodiment, the first drying section 26a and the second drying section 26b may be deployed separately among different drying boxes. Also, it is possible to prevent allowing the hot air and the superheated vapor to mix each other between the first drying section 26a and the second drying section 26b by means of a partition plate, an air curtain or the like between the first drying section 26a and the second drying section 26b among the drying box 42.

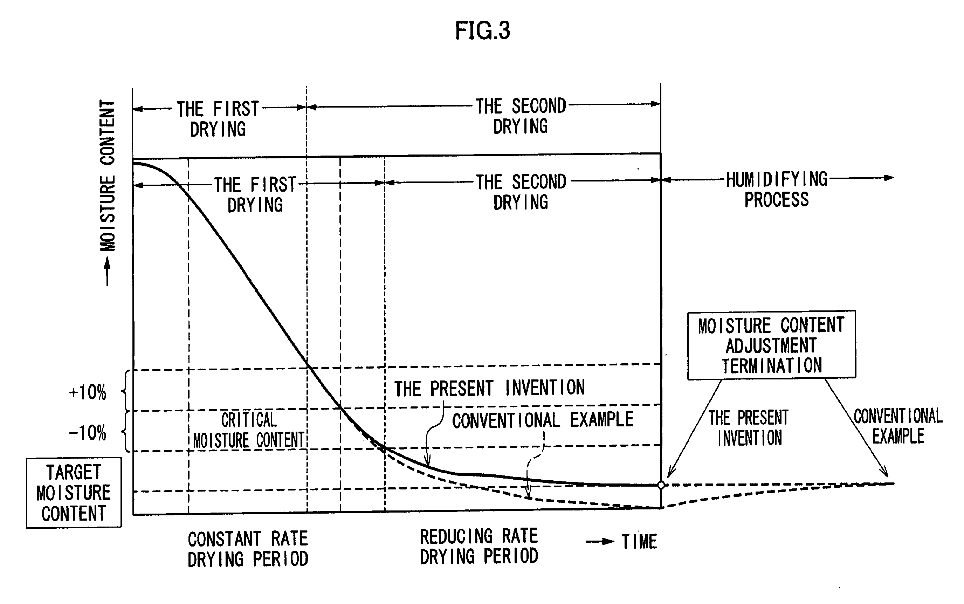

Next, an explanation about the situation of drying for the overcoat layer in the present invention will be described referring to Fig. 2 and Fig. 3. Fig. 3 is a graph showing a relation between the moisture contents of the overcoat layer and the lapse of time. The support 14 having the overcoat layer applied is conveyed through the slit-shaped opening into the drying box 42 among the drying apparatus 40, and while being supported by pass rollers 44 from its under surface, advances among the drying apparatus 40. In the first drying section 26a, hot air is blown toward the overcoat layer on the support 14 from the plurality of nozzles 46. This causes heating and drying by hot air until the moisture content in the overcoat layer on the support 14 reaches nearly ± 10 % of critical moisture content as shown in Fig. 3. The term "critical moisture content" is defined as the point on which the constant rate drying period transforms into the reducing rate drying period. Among the constant rate drying period, the temperature of the overcoat layer is approximately constant and a calorific value by hot air is used in evaporation of moisture. As a result, the water component continues evaporating with constant drying rate. After passing over "the critical moisture content", the drying rate falls down and the temperature of the overcoat layer begins to elevate.

Subsequently in the drying box 42, the support 14 is carried over the pass rollers 44's from the first drying section 26a into the second drying section 26b. In the second drying section 26a, hot air including the superheated vapor S is blown toward the overcoat layer on the support 14 from the plurality of nozzle 50's. In the second drying section 26b, the overcoat layer is dried until having predetermined moisture content finally as shown in Fig. 3. Blowing the superheated vapor S in addition to the hot air will control the moisture content in the overcoat layer at the termination timing among the second drying section 26b to be the target moisture content 2 to 8 % by weight in the overcoat layer on the coated substrate for presensitized printing plate. Because the drying is carried out at an elevated temperature, in the case where both preventing transfer of the overcoated membrane onto the pass rollers and suppressing changes with lapse of time after winding up become necessary, the moisture content will be finally adjusted in the humidifying process under the constant temperature and constant humidity condition after the web is cooled. The web is conveyed toward the winding up process while maintaining the overcoat layer controlled to the target moisture content in the humidifying process being under constant temperature and constant humidity condition. The humidifying process is provided for the purpose of maintaining or of highly precisely controlling the overcoat layer controlled to the target moisture content to the destination of the winding up process.

A dotted line in Fig. 3 illustrates a relation between moisture contents of the overcoat layer and the lapse of time in embodiments of a conventional technique and the present invention. As shown in Fig. 3, in the present invention, the first drying is carried out until becoming nearly ± 10 % of the critical moisture content, followed by the execution of the second drying. On the other hand, only the first drying is carried out in the conventional technique. As is apparent from Fig. 3, the overcoat layer was dried up to the absolute dry condition (moisture content of from 0 to 0.5 % by weight) in the conventional embodiment, for the purpose of preventing quality defects of the original plate of the planographic printing plate caused by unsatisfied drying of the overcoat layer and for the purpose of preventing troubles or so in the manufacturing apparatuses. Therefore, in the humidifying process, because the humidifying (addition of moisture) is executed until the moisture content in the overcoat layer becomes 2 to 8 % from the absolute dry condition; a relatively long humidifying time was needed. In order to improve the productivity, a humidifying process having a long humidifying zone was necessary and it was not appropriate for the space saving and the cost saving. In the present invention, the moisture content in the overcoat layer can reach the target moisture content at the timing of the second drying termination. Accordingly, the humidifying process having the long humidifying zone needed conventionally becomes unnecessary.

### Examples

Next, the present invention will be explained in detail by examples, but it should be noted that the present invention is not limited to the following examples. In the examples, a drying test of the overcoat layer is carried out utilizing a production line as shown in Fig. 1 and a drying apparatus 40 as shown in Fig. 2.

In the examples, a support with a width of 1000 mm, a thickness of 0.3 mm and made of aluminum is employed. After forming a photosensitive layer over the support, a coating solution (surface active agent / PVA (polyvinyl alcohol) / water) is applied in a wet coating amount of 35 cc/m² over the photosensitive layer using a bar coating machine as a coating apparatus. Drying the applied overcoat layer with conditions shown in Table 1, and varying the conditions via a process of cooling down after drying in various conditions of such as drying, steam auditioning, conditions and existence or not existing of employing a process of humidifying, or the like, the relation between the moisture content at the exit of the apparatus and the treated time is investigated, and whether the desired moisture contents were obtained or not in the desired treatment times is examined.

In the Comparative Examples, conventional dryings by hot air were carried out and the moisture contents were adjusted in the process of humidifying via a process of cooling down after drying in similar manners as the examples aiming for obtaining the desired moisture contents. The processes of cooling down were carried out by chilled air at the temperature of 20 °C. In the processes of humidifying, the humidity is adjusted at the temperature of 25 °C and at the humidity of 55 % HR (Relative Humidity). Employing an infrared moisture meter IRM-V (Trade Name, manufactured by CHINO Corporation), measurements of moisture contents in respective Examples and Comparative Examples were conducted. The line velocity of this time was 80m/min. Additionally, regarding with the evaluation about the characteristics of the photosensitive materials, total assessment of development property, sensitivity, printing durability, omission of membrane and fine remaining membrane was evaluated. The evaluation is carried out based on the criteria that the sample not permissible as a product corresponds to D, the sample permissible as a product corresponds to C, the sample permissible as a product and favorable corresponds to B, and the sample particularly favorable corresponds to A. Crystallinity of PVA in the overcoat layer is measured in accordance with an infrared (IR) method and a molecular state by heating was also analyzed.

The moisture contents in the overcoat layers just after drying are described in the columns of "moisture content (%) in membrane after drying". The times spent for humidifying in the process of humidifying with respect to the overcoat layer after drying are described in the columns of "times for humidifying after drying". In the process of humidifying, the moisture content will be adjusted and controlled for the purpose of getting target moisture content of the overcoat layer. The moisture contents in the over coat layers after passing through the processes for humidifying are described in the columns of "moisture content (%) in membrane after humidifying". This moisture content corresponds to the moisture content of the original plate of the planographic printing plate.

In Examples 1 to 11, the temperature and the flow rate of the drying wind to be fed into the first drying zone and the second drying zone are settled to be 150 °C and 6 m/sec respectively. The drying times in the first drying zone were varied to be 10 seconds, 15 seconds or 20 seconds. In the second drying zone, the temperature and the feeding amount of the superheated vapor were settled to be 150 °C and 300 g/m³ respectively and the feeding times were varied to be 0.3 to 15 seconds. Further in Examples 8 to 11, the times spent for humidifying in the process of humidifying are varied to be 10 seconds or 100 seconds.

In Examples 12 to 15, the temperature and the flow rate of the drying wind to be fed into the first drying zone and the second drying zone are settled to be 200 °C and 6 m/sec respectively. The drying times in the first drying zone were varied to be 10 seconds or 15 seconds. In the second drying zone, the temperature and the supplying amount of the superheated vapor were settled to be 200 °C and 300 g/m³ respectively and the feeding times were varied to be 0.5 to 15 seconds. In Examples 16 to 18, the feeding amounts of the superheated vapor in the second drying zone are further varied to be 400 g/m³, 200 g/m³ or 100 g/m³.

In Comparative Examples 1 to 3, the temperature and the flow rate of the drying wind were settled to be 150 °C and 6 m/sec respectively and the drying times were varied to be 10 seconds, 15 seconds or 20 seconds. Further in Comparative Examples 4 to 8, the times spent for humidifying in the process of humidifying are varied to be from 10 to 200 seconds.

In Example 1, because the feeding time of the superheated vapor was long, the moisture content exceeded the target moisture content and although the sample achieved the permissible level as the product, the quality turned worse a little. In Examples 2 to 4, a sufficient heating and the target moisture content were achieved and the characteristics exhibited no problem. Because the heating was insufficient in Example 5, and because the moisture contents lacked in Examples 6 and 7, although the samples achieved the permissible level as the products, the quality turned worse a little.

In Examples 8 to 11, the coated substrates were made to pass through the process of humidifying after drying. In Examples 8, 10 and 11, the sufficient heating and the target moisture content were achieved and the characteristics exhibited no problem. Because the heating is insufficient in Example 9, although the sample achieved the permissible level as the product, the quality turned worse a little.

In Examples 12 to 16, the sufficient heating and the target moisture content were achieved and the characteristics exhibited no problem. In Examples 17 and 18, the quality turned worse a little owing to the insufficient water contents.

In Comparative Examples 1 to 3, only an ordinary drying with hot air was conducted respectively without passing through the process of humidifying. In Comparative Example 1, the insufficient heating and exceeding over the target moisture content failed to achieve the permissible characteristics. Both the insufficient heating in Comparative Example 2, and low moisture content in Comparative Example 3 failed to achieve the permissible characteristics.

In Comparative Examples 4 to 8, the original plates are made to pass through the process of humidifying after drying. In order to satisfy the characteristics of the photosensitive materials sufficiently, it was necessary to make the original plate staying at the process of humidifying for 50 seconds or longer.

As apparently understandable from Table 1, because the moisture contents are adjustable to the predetermined values immediately after drying and the membranes can be heated enough in Examples, both the drying zones and the humidifying zones can be abbreviated. Particularly, the aimed overcoat layer can be obtained without any humidifying zone. Further, even in the state near to an absolute dry condition, sending the superheated vapor for a short time afterwards enabled to rapidly feed the water component and to abbreviate the humidifying time for adjusting to the target moisture content and although the humidifying time is 10 seconds, it was possible to achieve the level of no problem in quality.

This shows that when the vapor drying is employed in the second drying, it is possible to control to the aimed predetermined moisture content by settling the second drying time as the preferred time, even though it is outside the range of generally needed 2 to 8 %. By controlling the second drying time, the overcoat layer in the original plate of the planographic printing plate can be arranged to a desired target moisture content of each type in a short time.

In the Comparative Examples, the target moisture content was not achieved when the humidifying time was not longer than 50 seconds, and any permissible level as the product was not achieved too. For the purpose of achieving permissible level as the product and more favorable, it was necessary that the drying time was not shorter than 150 seconds, which is the shortest. This shows that the humidifying process in the present invention improved the production efficiency 15 times as compared with the conventional technique.

As a factor deciding the characteristic of the photosensitive materials in the coated substrate for the presensitized printing plate, it is known that the moisture content in the membrane and heating amount are important.

Regarding with the moisture content in the membrane, a condition that satisfies the moisture content exists even in only the first drying zone. Although it is possible to proceed in a short time, a treatment such as changing the drying time depending on each type (i.e., changing over of web conveying speed or drying zones) is necessary and a loss of junction will increase. Because the control of the moisture content is carried out in only the first drying zone in which the moisture content is reduced at a stretch, the control is difficult and there are demerits such that it tends to cause a moisture content shortage or a moisture content surplus. Concerning with the heating amount, when the drying is carried out only in the first drying zone, problems such that the energy for heat treatment (curing) of needed photosensitive layer lacks and the like will occur. Those problems can be dissolved by an application of the superheated vapor as the second drying.

Further, as the effects of the present invention, aside from the above mentioned improvement of the productivity, cost saving and space saving, there is a possibility called "control of the vapor amount of the heating vapor" controllable by factors capable of being changed over in a short time as compared with other drying condition and humidifying condition. Accordingly, the degree of freedom in settling the condition will leapingly increase enabling to expect a stabilization of quality by a feedback control or the settling the condition with high robustness and a effect of tremendous increase in the types producible in the same apparatus and in the same speeds.

**Table 1**

| | Drying Condition | | | Superheated Vapor Applying Condition | | | Humidifying Time After Drying | Moisture Content (%) in Membrane | | Photosensitive Characteristics |
|---|---|---|---|---|---|---|---|---|---|---|
| | Temperature | Flow Rate | Time | Temperature | Vapor Amount | Time | | | | |
| | °C | m/sec | seconds | °C | g/m³ | seconds | seconds | After Drying | After Humidifying | Evaluation |
| Ex. 1 | 150 | 6 | 10 | 150 | 300 | 15 | 0 | 9 | - | B |
| Ex. 2 | 150 | 6 | 10 | 150 | 300 | 10 | 0 | 7 | - | A |
| Ex. 3 | 150 | 6 | 10 | 150 | 300 | 5 | 0 | 5 | - | A |
| Ex. 4 | 150 | 6 | 15 | 150 | 300 | 0.5 | 0 | 6 | - | A |
| Ex. 5 | 150 | 6 | 15 | 150 | 300 | 0.3 | 0 | 6 | - | B |
| Ex. 6 | 150 | 6 | 20 | 150 | 300 | 0.5 | 0 | 2 | - | B |
| Ex. 7 | 150 | 6 | 20 | 150 | 300 | 0.3 | 0 | 1.5 | - | C |
| Ex. 8 | 150 | 6 | 15 | 150 | 300 | 0.5 | 10 | 6 | 6 | A |
| Ex. 9 | 150 | 6 | 15 | 150 | 300 | 0.3 | 10 | 6 | 6 | B |
| Ex. 10 | 150 | 6 | 20 | 150 | 300 | 0.5 | 10 | 2 | 3 | A |
| Ex. 11 | 150 | 6 | 20 | 150 | 300 | 0.3 | 10 | 1.5 | 3 | A |
| Ex. 12 | 200 | 6 | 10 | 200 | 300 | 15 | 0 | 8 | - | A |
| Ex. 13 | 200 | 6 | 10 | 200 | 300 | 10 | 0 | 5 | - | A |
| Ex. 14 | 200 | 6 | 10 | 200 | 300 | 5 | 0 | 4 | - | A |
| Ex. 15 | 200 | 6 | 15 | 200 | 300 | 0.5 | 0 | 2.5 | - | A |
| Ex. 16 | 200 | 6 | 15 | 200 | 400 | 0.5 | 0 | 3.5 | - | A |
| Ex. 17 | 200 | 6 | 15 | 200 | 200 | 0.5 | 0 | 2 | - | A |
| Ex. 18 | 200 | 6 | 15 | 200 | 100 | 0.5 | 0 | 1.5 | - | B |
| Co. Ex. 1 | 150 | 6 | 10 | - | - | - | 0 | 13 | - | C |
| Co. Ex. 2 | 150 | 6 | 15 | - | - | - | 0 | 5 | - | D |
| Co. Ex. 3 | 150 | 6 | 20 | - | - | - | 0 | 0-0.5 | - | D |
| Co. Ex. 4 | 150 | 6 | 20 | - | - | - | 200 | 0-0.5 | 8 | B |
| Co. Ex. 5 | 150 | 6 | 20 | - | - | - | 150 | 0-0.5 | 5 | B |
| Co. Ex. 6 | 150 | 6 | 20 | - | - | - | 50 | 0-0.5 | 2 | C |
| Co. Ex. 7 | 150 | 6 | 20 | - | - | - | 10 | 0-0.5 | 1 | B |
| Co. Ex. 8 | 200 | 6 | 20 | - | - | - | 50 | 0-0.5 | 1.5 | B |

| | | | | | | | | | | |
|---|---|---|---|---|---|---|---|---|---|---|
| Additionally in Table 1, "Ex." means "Example", and "Co. Ex." means "Comparative Example". | | | | | | | | | | |

As apparently understandable from the results, for achieving the same levels of photosensitive material characteristics in each of Examples 1 to 11, it was able to reduce the humidifying time shorter than the Comparative Examples. As a result, according to the method for manufacturing an original plate of the planographic printing plate of the present invention, adding the drying process in which the superheated vapor is fed enables to improve productivity. Further, a needless of prolonging a passage length of the humidifying zone can contribute to cost saving and space saving.

An application of the present invention onto the materials whose moisture content in the membrane after drying becomes an important characteristic indicator enables to make the apparatus compact, to eliminate a velocity constraint of drying and humidifying apparatus, or to obtain a state of the membrane having a desired moisture content; thereby obtaining leaping effects in the degrees of freedom about cost, characteristics and apparatus condition.

## Claims

1. A method for manufacturing an original plate (14A) of a planographic printing plate, **characterized by** comprising:
a process of forming a photosensitive layer on a substrate (14);
a process of coating an overcoat layer over the photosensitive layer;
a first drying process of supplying hot air toward the overcoat layer; and
a second drying process of supplying hot air and superheated vapor (S) toward the overcoat layer after the first drying process, wherein
the original plate (14A) of a planographic printing plate is photopolymerizable.

2. The method for manufacturing an original plate (14A) of a planographic printing plate according to claim 1, wherein the overcoat layer contains a water-soluble polymer.

3. The method for manufacturing an original plate (14A) of a planographic printing plate according to claim 2, wherein the water-soluble polymer is a water-soluble polymer whose main component is polyvinyl alcohol.

4. The method for manufacturing an original plate (14A) of a planographic printing plate according to any one of claims 1 to 3, wherein the second drying process starts when a moisture content of the overcoat layer is within ± 10 % of its critical moisture content.

5. The method for manufacturing an original plate (14A) of a planographic printing plate according to any one of claims 1 to 4, wherein a supplying time of the superheated vapor (S) is not less than 0.5 second but not more than 15 seconds.

6. The method for manufacturing an original plate (14A) of a planographic printing plate according to any one of claims 1 to 5, wherein a supplying amount of the superheated vapor (S) is not less than 50 g/m³ but not more than 500 g/m³, and preferably not less than 100 g/m³ but not more than 400 g/m³.

7. The method for manufacturing an original plate (14A) of a planographic printing plate according to any one of claims 1 to 6, wherein temperature of the superheated vapor (S) is within ± 20 °C and preferably within ± 5 °C of temperature of the hot air.

8. The method for manufacturing an original plate (14A) of a planographic printing plate according to any one of claims 1 to 7, further comprising:
a process of cooling down the substrate (14) over which the photosensitive layer and the overcoat layer are formed; and
a process of adjusting the moisture content of the overcoat layer after the process for cooling down the substrate (14).

9. The method for manufacturing an original plate (14A) of a planographic printing plate according to claim 8, wherein
the process of cooling down the substrate (14) is controlled by dew-point of not more than 18 °C, and
the temperature of the substrate is controlled within a range of 25 °C to 40 °C by a wind with the temperature of 20 ± 5 °C.

10. An original plate (14A) of a planographic printing plate, **characterized in that** the original plate is manufactured by the method for manufacturing an original plate of a planographic printing plate according to any one of claims 1 to 9.
